(19) Europäisches Patentamt
European Patent Office
Office européen des brevets

(11) **EP 0 735 679 B1**

(12) **EUROPÄISCHE PATENTSCHRIFT**

(45) Veröffentlichungstag und Bekanntmachung des Hinweises auf die Patenterteilung:
**02.06.2004   Patentblatt 2004/23**

(51) Int Cl.⁷: **H03K 5/08**

(21) Anmeldenummer: **95104827.1**

(22) Anmeldetag: **31.03.1995**

(54) **Flankendetektor**

Edge detector

Détecteur de pente

(84) Benannte Vertragsstaaten:
**DE FR GB IT NL**

(43) Veröffentlichungstag der Anmeldung:
**02.10.1996   Patentblatt 1996/40**

(73) Patentinhaber: **TEXAS INSTRUMENTS DEUTSCHLAND GMBH**
**85356 Freising (DE)**

(72) Erfinder: **Bayer, Erich**
**D-84030 Piflas (DE)**

(74) Vertreter: **Degwert, Hartmut, Dipl.-Phys. et al**
**Prinz & Partner GbR,**
**Manzingerweg 7**
**81241 München (DE)**

(56) Entgegenhaltungen:
**GB-A- 2 120 030          US-A- 3 838 448**
**US-A- 4 571 547**

**Beschreibung**

Die Erfindung betrifft einen Flankendetektor zum Erzeugen von Ausgangssignalen in Abhängigkeit von positiven und/oder negativen Flanken eines Eingangssignals.

Flankendetektoren werden unter anderem zur Erkennung von ansteigenden oder abfallenden Flanken von Rechtecksignalen eingesetzt, die beispielsweise über einen Bus übertragen werden, der als gemeinsamer Übertragungsweg für einen Datenaustausch zwischen zwei oder mehreren angeschlossenen elektronischen Geräten dient. Auch werden solche Detektoren zum Detektieren von physiologischen Signalen verwendet, wie zum Beispiel in US 4,571,547 offenbart. In entsprechenden Bus-Systemen können insbesondere Adreß-, Daten- und/oder Steuer-Signale übertragen werden. Entscheidend für eine möglichst fehlerfreie Kommunikation zwischen den einzelnen Geräten ist unter anderem, daß die von den jeweiligen Geräten zu empfangenden Signale sicher erkannt werden.

Demzufolge werden bei einer Reihe von bekannten Bus-Systemen

Komparatoren verwendet, durch die das Empfangssignal direkt mit einem festen Bezugssignal verglichen wird. Problematisch bei diesen herkömmlichen Bus-Systemen ist nun aber, daß eine beispielsweise durch Einstreuungen bedingte Verschiebung des Massepegels die Signalerkennung erschweren oder sogar verhindern kann. Insbesondere kann nicht ausgeschlossen werden, daß sich der Massepegel bis in den Bereich des festen Bezugssignalpegels verschiebt. Zumindest im letzteren Fall ist eine eindeutige Signalerkennung praktisch ausgeschlossen.

Zudem ist es wünschenswert, die Zuverlässigkeit der Flankenerkennung durch Heranziehen weiterer Kriterien wie insbesondere das der Anstiegsgeschwindigkeit oder Flankensteilheit zu erhöhen. Hierbei kann es jedoch zu Problemen kommen, die daherrühren, daß eine gegenseitige Abhängigkeit zwischen der erfaßten Anstiegsgeschwindigkeit und der Schwellenspannung nicht ausgeschlossen werden kann. Die Gefahr einer solchen gegenseitigen Abhängigkeit besteht insbesondere dann, wenn die Anstiegsgeschwindigkeit des Eingangssignals im Bereich der zulässigen minimalen Anstiegsgeschwindigkeit liegt. Zumindest in diesem Fall muß nämlich damit gerechnet werden, daß sich der jeweils verwendete Bezugsspannungspegel bereits während des Übergangs des Eingangssignals in den neuen Zustand ändert, was insbesondere zu einer fehlerhaften Erfassung der Anstiegsgeschwindigkeit des Eingangssignals führen kann.

Ziel der Erfindung ist es daher, einen Flankendetektor der eingangs genannten Art zu schaffen, der bei einfachstem Schaltungsaufbau eine möglichst störungssichere, unverfälschte Signalerkennung gewährleistet.

Diese Aufgabe wird nach der Erfindung gelöst durch einen Regelkreis, durch den ein an einem Speicherelement abgreifbarer Bezugsspannungspegel mit einer vorgebbaren ersten Pegeländerungsgeschwindigkeit kontinuierlich an den Eingangsspannungspegel angeglichen wird, durch wenigstens einen Vergleichskreis, der ein für das Auftreten einer Flanke repräsentatives Ausgangssignal liefert, wenn sich der Eingangsspannungspegel um wenigstens einen vorgebbaren relativen Schwellenwert gegenüber dem Bezugsspannungspegel ändert, und durch ein im Regelkreis enthaltenes Verzögerungsglied, dessen eine Verzögerung des Bezugsspannungspegelangleichs bewirkende Verzögerungszeit gleich dem Verhältnis von dem vorgebbaren relativen Schwellenwert zu der vorgebbaren ersten Pegeländerungsgeschwindigkeit gewählt ist.

Aufgrund dieser Ausbildung wird eine jeweilige Flanke auf zuverlässige Weise stets dann erfaßt, wenn bei einer betreffenden Änderung des Eingangssignals dessen Anstiegsgeschwindigkeit oder Flankensteilheit größer als eine vorgebbare zulässige minimale Anstiegsgeschwindigkeit ist und ein vorgebbarer relativer Schwellenwert überschritten wird, wobei die zulässige minimale Anstiegsgeschwindigkeit und der relative Schwellenwert unabhängig voneinander festlegbar und bei der Erkennung einer jeweiligen Signalflanke auch unabhängig voneinander, d.h. ohne gegenseitige Beeinflussung erfaßbar sind. Der Bezugsspannungspegel wird mit der vorgebbaren ersten Pegeländerungsgeschwindigkeit kontinuierlich an den jeweiligen Ruhespannungspegel des Eingangssignals angepaßt, wobei mit dieser ersten Pegeländerungsgeschwindigkeit gleichzeitig auch die zulässige minimale Anstiegsgeschwindigkeit vorgebbar ist. Voraussetzung für die Erkennung einer jeweiligen Flanke ist somit, daß die Anstiegsgeschwindigkeit des Eingangssignals größer als diese vorgebbare erste Pegeländerungsgeschwindigkeit ist. Nur in diesem Fall kann der relative Schwellenwert erreicht werden, nach dessen Überschreiten ein für das Auftreten der Flanke repräsentatives Ausgangssignal erzeugt wird. Wird dagegen dieser relative Schwellenwert nicht erreicht, so wird kein entsprechendes Ausgangssignal geliefert, selbst wenn die Anstiegsgeschwindigkeit des Eingangssignals über der zulässigen minimalen Anstiegsgeschwindigkeit, d.h. über der ersten Pegeländerungsgeschwindigkeit liegen sollte. Ein wesentlicher Vorteil der Erfindung besteht nun darin, daß aufgrund des Verzögerungsglieds, das im der Bezugsspannungspegelanpassung dienenden Regelkreis vorgesehen ist, eine Änderung des Bezugsspannungspegels vor Erreichen des Schwellenwertes und damit vor der eigentlichen Flankenerkennung selbst dann mit Sicherheit ausgeschlossen ist, wenn die Anstiegsgeschwindigkeit des Eingangssignals nur geringfügig größer als die zulässige minimale Anstiegsgeschwindigkeit ist. Auch in diesem kritischen Fall liegt ein genau definierter relativer, d.h. auf den vorherigen Ruhespannungspegel bezogener Schwellenwert vor. Die erfaßte Anstiegsgeschwindigkeit ist stets unabhängig von der zu erfassenden Spannung. Eine Verfälschung des erfaßten Wertes durch eine sich während einer Signaländerung einstellende Verschiebung des Bezugsspannungspegels und damit des relativen Schwellenwertes ist ausgeschlossen. Umgekehrt ist der für eine Flankenerkennung zu überschreitende relative Schwellenwert unabhängig von der jeweiligen Anstiegsgeschwindigkeit des Eingangssignals und in jedem Fall durch den vorgebbaren Wert genau bestimmt.

Gemäß einer bevorzugten Ausführungsvariante enthält der das Verzögerungsglied und das Speicherelement enthaltende Regelkreis ferner eine dem Speicherelement zugeordnete erste Lade-/Entladeschaltung und einen ersten Komparator, an dessen einem Eingang der Eingangsspannungspegel und an dessen anderem Eingang der Bezugsspannungspegel anliegt, wobei der Ausgang des ersten Komparators über das Verzögerungsglied mit einem Steuereingang der ersten Lade-/Entladeschaltung verbunden ist. Hierbei bewirkt das Verzögerungsglied, daß die über die erste Lade-/Entladeschaltung erfolgende Anpassung des Bezugsspannungspegels an den jeweiligen Ruhespannungspegel des Eingangssignals um die definierte Verzögerungszeit, die gleich dem Verhältnis von dem vorgebbaren relativen Schwellenwert zu der vorgebbaren ersten Pegeländerungsgeschwindigkeit gewählt ist, verzögert angesteuert wird.

Ist das Speicherelement zweckmäßigerweise ein Kondensator, so kann die erste Lade-/Entladeschaltung ein erstes Stromquellenpaar enthalten, um einen ersten Lade- bzw. Entladestrom zu erzeugen, dessen Wert zusammen mit der Kapazität des Kondensators die vorgebbare erste Pegeländerungsgeschwindigkeit bestimmt. Die erste Pegeländerungsgeschwindigkeit kann somit über den Lade- bzw. Entladestrom und/oder die Kapazität des Kondensators beliebig vorgegeben werden.

Dem Speicherelement kann vorteilhafterweise eine zweite Lade-/Entladeschaltung zugeordnet sein, die einen Steuereingang aufweist, der vom Ausgangssignal des Vegleichskreises beaufschlagt ist, um den am Speicherelement abgreifbaren Bezugsspannungspegel in Abhängigkeit vom Auftreten des Ausgangssignals mit einer vorgebbaren zweiten Pegeländerungsgeschwindigkeit an den um den vorgebbaren relativen Schwellenwert verringerten Eingangsspannungspegel anzugleichen, wobei die vorgebbare zweite Pegeländerungeschwindigkeit größer als die erste ist. Zweckmäßigerweise ist diese zweite Pegeländerungeschwindigkeit deutlich, vorzugsweise um ein vielfaches größer als die erste, so daß beispielsweise unmittelbar nach dem Auftreten eines für eine jeweilige Flanke repräsentativen Ausgangssignals der Bezugsspannungspegel so schnell wie möglich nachgeführt, d.h. an den um den vorgebbaren relativen Schwellenwert verringerten Eingangsspannungspegel angeglichen wird. Zur Flankenerkennung ist es nämlich völlig ausreichend, wenn bei hinreichender Anstiegsgeschwindigkeit der vorgebbare Schwellenwert überschritten wird. Durch diese Ausführungsvariante können somit die jeweiligen Erholungszeiten beträchtlich verkürzt werden.

Weitere vorteilhafte Ausführungsvarianten der Erfindung sind in den Unteransprüchen angegeben.

Die Erfindung wird im folgenden anhand von Ausführungsbeispielen unter Bezugnahme auf die Zeichnung näher erläutert; in dieser zeigen:

Fig. 1    ein Prinzipschaltbild einer ersten Ausführungsform eines Flankendetektors,

Fig. 2    ein Prinzipschaltbild eines Teils einer zweiten Ausführungsform eines Flankendetektors und

Fig. 3    ein Prinzipschaltbild eines Teils einer dritten Ausführungsform eines Flankendetektors.

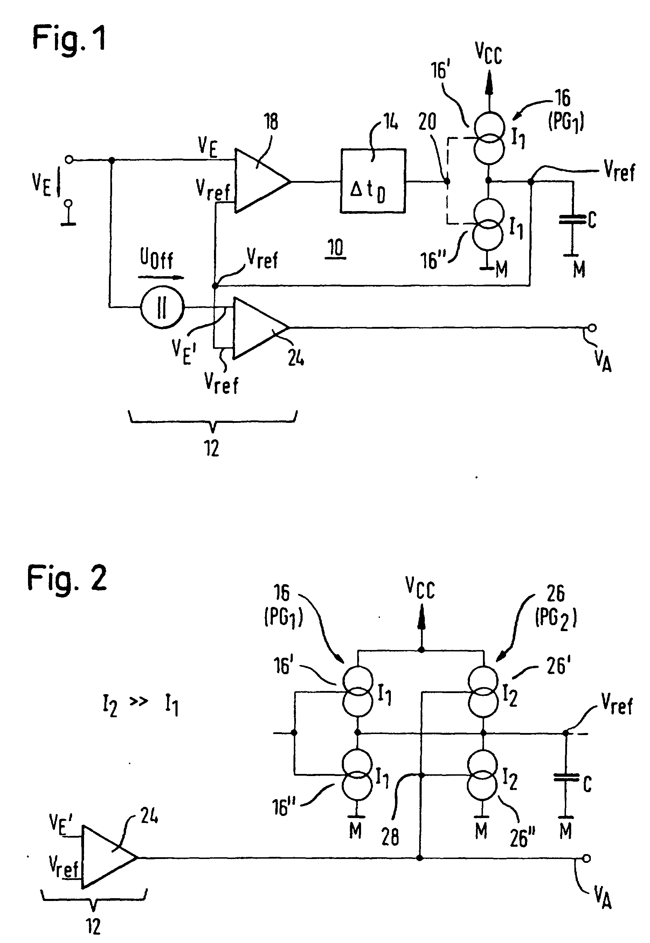

Der in Fig. 1 schematisch dargestellte Flankendetektor dient allgemein zum Erzeugen von Ausgangssignalen in Abhängigkeit von positiven und/oder negativen Flanken eines Eingangssignals.

Er enthält einen Regelkreis 10, durch den ein Bezugsspannungspegel $V_{ref}$ mit einer vorgebbaren ersten Pegeländerungsgeschwindigkeit $PG_1$ kontinuierlich an den Eingangsspannungspegel $V_E$ angeglichen wird. Der Bezugsspannungspegel $V_{ref}$ wird an einem einseitig an Masse M liegenden, als Speicherelement dienenden Kondensator C abgegriffen.

Außer dem Kondensator C enthält der Regelkreis 10 eine dem Kondensator C zugeordnete erste Lade-/Entladeschaltung 16, einen ersten Komparator 18 und ein zwischen den Ausgang des Komparators 18 und einen Steuereingang 20 der ersten Lade-/Entladeschaltung 16 geschaltetes Verzögerungsglied 14.

Die erste Lade-/Entladeschaltung 16 enthält ein erstes Stromquellenpaar 16', 16'', dessen Stromquellen über den Steuereingang 20 der Lade-/Entladeschaltung 16 gegensinnig ansteuerbar sind, um einen ersten Lade- bzw. Entladestrom $I_1$ zu erzeugen, dessen konstanter Wert zusammen mit der Kapazität des Kondensators C die vorgebbare erste Pegeländerungsgeschwindigkeit $PG_1$ bestimmt. Hierbei ist die der Masseseite gegenüberliegende, den Bezugsspannungspegel $V_{ref}$ aufweisende Seite des Kondensators C mit dem zwischen den beiden Stromquellen des Stromquellenpaares 16', 16'' liegenden Schaltungspunkt verbunden. Eine Stromquelle 16' ist an die Versorgungsspannung $V_{CC}$ angeschlossen, während die andere Stromquelle 16'' an Masse M liegt. Der Kondensator C wird somit über die an der Versorgungsspannung $V_{CC}$ liegende Stromquelle 16' geladen und über die an Masse M liegende Stromquelle 16'' entladen.

Am einen Eingang des ersten Komparators 18 liegt der Eingangsspannungspegel $V_E$. Der andere Eingang dieses Komparators 18 ist mit der der Masseseite gegenüberliegenden Seite des Kondensators C verbunden und damit vom Bezugsspannungspegel $V_{ref}$ beaufschlagt.

Die erste Lade-/Entladeschaltung 16 wird demnach über das Verzögerungsglied 14 vom ersten Komparator 18 in Abhängigkeit vom Ergebnis des Vergleichs zwischen dem Eingangsspannungspegel $V_E$ und dem Bezugsspannungspegel $V_{ref}$ angesteuert, wobei über den Regelkreis 10 erreicht wird, daß der Bezugsspannungspegel $V_{ref}$ aufgrund des Verzögerungsglieds 14 um $\Delta t_D$ verzögert mit der vorgebbaren ersten Pegeländerungsgeschwindigkeit $PG_1$ an den Eingangsspannungspegel $V_E$ angeglichen wird.

Der Flankendetektor enthält ferner einen Vergleichskreis 12 mit einem zweiten Komparator 24, an dessen einem Eingang ein Spannungspegel $V_E'$ anliegt, der gleich dem um einen vorgebbaren relativen Schwellenwert $U_{Off}$ verringerten Eingangsspannungspegel $V_E$ ist, und an dessen anderem Eingang der Bezugsspannungspegel $V_{ref}$ anliegt. Der vorgebbare relative Schwellenwert $U_{Off}$ kann beispielsweise durch eine Gleichspannungsquelle erzeugt werden, die zwischen den betreffenden Eingang des zweiten Komparators 24 und den den Eingangsspannungspegel $V_E$ aufweisenden Eingang des Flankendetektors geschaltet ist. Der Bezugsspannungspegel $V_{ref}$ wird wiederum vom Kondensator C abgegriffen, so daß sowohl ein Eingang des ersten Komparators 18 als auch ein Eingang des zweiten Komparators 24 mit der betreffenden Seite des Kondensators C verbunden ist.

Der dem Vergleichskreis 12 zugeordnete zweite Komparator 24 liefert an seinem Ausgang somit ein für das Auftreten einer Flanke repräsentatives Ausgangssignal $V_A$, wenn sich der Eingangsspannungspegel $V_E$ um wenigstens den vorgebbaren relativen Schwellenwert $U_{Off}$ gegenüber dem Bezugsspannungspegel $V_{ref}$ ändert.

Die vorgebbare erste Pegeländerungsgeschwindigkeit $PG_1$, mit der der Bezugsspannungspegel $V_{ref}$ kontinuierlich an den Eingangsspannungspegel $V_E$ angeglichen wird, ist durch den Wert des ersten Lade- bzw. Entladestroms $I_1$ und die Kapazität des Kondensators C bestimmt, d.h. durch die folgende Beziehung gegeben:

$$PG_1 = \Delta U_c/\Delta t = I_1/C \qquad (1)$$

Durch diese über $I_1$ und C beliebig vorgebbare erste Pegeländerungsgeschwindigkeit $PG_1$ wird gleichzeitig die zulässige minimale Anstiegsgeschwindigkeit bestimmt, die das Eingangssignal für eine Flankenerkennung aufweisen muß. Der beispielsweise über eine Gleichspannungsquelle vorgebbare relative Schwellenwert $U_{Off}$ kann nur erreicht bzw. überschritten werden, wenn die Anstiegsgeschwindigkeit des Eingangssignals gleich bzw. größer als diese vorgebbare erste Pegeländerungsgeschwindigkeit $PG_1$ wird. Andernfalls bleibt der am einen Eingang des zweiten Komparators 24 anliegende Spannungspegel $V_E'$ unter dem Bezugsspannungspegel $V_{ref}$, so daß in diesem Fall der Komparator 24 kein für das Auftreten einer jeweiligen Flanke repräsentatives Ausgangssignal $V_A$ liefert. Ist die Anstiegsgeschwindigkeit des Eingangssignals dagegen größer als die vorgebbare erste Pegeländerungsgeschwindigkeit $PG_1$ und wird der Schwellenwert $U_{Off}$ überschritten, so tritt an den beiden Eingängen des zweiten Komparators 24 ein positives Differenzsignal auf, woraufhin ein für die betreffende Flanke repräsentatives Ausgangssignal $V_A$ geliefert wird.

Die durch das Verzögerungsglied 14 in den Regelkreis 10 eingeführte Verzögerungszeit $\Delta t_D$ ist gleich dem Verhältnis von dem vorgebbaren relativen Schwellenwert $U_{Off}$ zu der vorgebbaren ersten Pegeländerungsgeschwindigkeit $PG_1$ gewählt. Sie ergibt sich demnach aus der folgenden Beziehung:

$$\Delta t_D = U_{Off}/PG_1 = U_{Off} * C/I_1 \qquad (2)$$

Diese durch das Verzögerungdsglied 14 in den Regelkreis 10 eingeführte Verzögerungszeit $\Delta t_D$ ist demnach so gewählt, daß eine Änderung des Bezugsspannungspegels vor Erreichen des Schwellenwertes und damit vor der eigentlichen Flankenerkennung selbst dann mit Sicherheit ausgeschlossen ist, wenn die Anstiegsgeschwindigkeit nur geringfügig größer als die durch die erste Pegeländerungsgeschwindigkeit $PG_1$ vorgegebene zulässige minimale Antiegsgeschwindigkeit ist. Auch in diesem kritischen Fall liegt somit ein genau definierter relativer, d.h. auf den vorherigen Ruhespannungspegel bezogener Schwellenwert vor. Der gegenüber dem vorherigen Ruhespannungspegel tatsächlich zu überschreitende Schwellenwert ist damit unabhängig von der jeweiligen Anstiegsgeschwindigkeit des Eingangssignals. Die zulässige minimale Anstiegsgeschwindigkeit und der relative Schwellenwert, die für eine Flankenerkennung überschritten werden müssen, sind unabhängig voneinander vorgebbar und beim Erfassen der jeweiligen Signalflanke auch unabhängig voneinander, d.h. ohne gegenseitige Beeinflussung erfaßbar.

Die Funktionsweise des in Fig. 1 dargestellten Ausführungsbeispiels ist wie folgt:

Durch den Regelkreis 10 wird der Bezugsspannungspegel $V_{ref}$ mit der über die erste Lade-/Entladeschaltung 16 vorgebbaren ersten Pegeländerungsgeschwindigkeit $PG_1$ verzögert durch die Verzögerungszeit $\Delta t_D$ an den Eingangsspannungspegel $V_E$ angeglichen. Mit der relativ langsamen ersten Pegeländerungsgeschwindigkeit $PG_1$ erfolgt somit eine kontinuierliche Anpassung des Bezugsspannungspegels $V_{ref}$ an den jeweiligen Ruhespannungspegel des Eingangssignals. Mit dieser ersten Pegeländerungsgeschwindigkeit $PG_1$ wird gleichzeitig auch die zulässige minimale Anstiegsgeschwindigkeit bestimmt, die für eine Flankenerkennung überschritten werden muß.

Ist die Anstiegs- bzw. Änderungsgeschwindigkeit des Eingangssignals kleiner als die erste Pegeländerungsgeschwindigkeit $PG_1$, so kann der Bezugsspannungspegel $V_{ref}$ dem Eingangsspannungspegel $V_E$ folgen. Der Schwellenwert $U_{Off}$ wird in diesem Fall nicht erreicht, so daß am Ausgang des zweiten Komparators 24 auch kein für das Auftreten einer Flanke repräsentatives Ausgangssignal $V_A$ auftritt. Im statischen Zustand, d.h. bei gleichbleibendem Eingangsspannungspegel $V_E$ (Gleichspannungszustand) bewirkt der Regelkreis 10, daß die zwischen den Eingängen des ersten Komparators 18 liegende Differenzspannung Null wird, d.h. der Bezugsspannungspegel $V_{ref}$ gleich dem Eingangsspannungspegel $V_E$ wird.

Ändert sich demgegenüber das Eingangssignal mit einer Anstiegsgeschwindigkeit, die größer als die vorgebbare erste Pegeländerungsgeschwindigkeit $PG_1$ ist, so kann sich der Eingangsspannungspegel $V_E$ aufgrund der langsameren Nachführung des Bezugsspannungspegels zunehmend gegenüber diesem Bezugsspannungspegel $V_{ref}$ ändern. Dies ist eine Voraussetzung dafür, daß zwischen dem Eingangsspannungspegel $V_E$ und dem Bezugsspannungspegel $V_{ref}$ überhaupt eine für eine Flankenerkennung erforderliche Spannungsdifferenz auftreten kann. Wird nun im weiteren Verlauf der Änderung des Eingangsspannungspegels $V_E$ gegenüber dem dem vorherigen Ruhespannungspegel des Eingangssignals entsprechenden Bezugsspannungspegel $V_{ref}$ der Schwellenwert $U_{Off}$ überschritten, so wird der am einen Eingang des zweiten Komparators 24 anliegende Spannungspegel $V_E'$ größer als der am anderen Eingang dieses Komparators 24 anliegende Bezugsspannungspegel $V_{ref}$, worauf am Ausgang des Komparators 24 ein für die jeweilige Flanke repräsentatives Ausgangssignal $V_A$ geliefert wird.

Aufgrund des Verzögerungsglieds 14 wird die erste Lade-/Entladeschaltung 16 stets um die Zeit $\Delta t_D$ verzögert vom Ausgangssignal des ersten Komparators 18 angesteuert, so daß auch der Angleich des Bezugsspannungspegels $V_{ref}$ an den Eingangsspannungspegel $V_E$ entsprechend verzögert erfolgt.

Nachdem diese Verzögerungszeit $\Delta t_D$ gleich dem Verhältnis von dem vorgebbaren relativen Schwellenwert $U_{Off}$ zu der vorgebbaren ersten Pegeländerungsgeschwindigkeit $PG_1$ gewählt ist (vgl. die obige Beziehung 2), sind die durch die erste Pegeländerungsgeschwindigkeit $PG_1$ vorgebbare zulässige minimale Anstiegsgeschwindigkeit und der beispielsweise durch eine Gleichspannungsquelle vorgebbare relative Schwellenwert $U_{Off}$, die für eine jeweilige Flankenerkennung überschritten werden müssen, unabhängig voneinander einstellbar und bei der Signalerkennung auch unabhängig voneinander, d.h. ohne gegenseitige Beeinflussung erfaßbar.

Die erfaßte Anstiegsgeschwindigkeit ist stets unabhängig von der zu erfassenden Spannung. Eine Verfälschung des erfaßten Wertes durch eine sich während einer Signaländerung einstellende Verschiebung des Bezugsspannungspegels und damit des relativen Schwellenwertes ist ausgeschlossen. Umgekehrt ist der für eine Flankenerkennung zu überschreitende relative Schwellenwert $U_{Off}$ unabhängig von der jeweiligen Anstiegsgeschwindigkeit des Eingangssignals und in jedem Fall eindeutig durch ein und dieselbe, beispielsweise durch eine Gleichspannungsquelle erzeugte vorbestimmte Schwellenspannung bestimmt. Dies gilt insbesondere auch für den kritischen Fall, daß die Anstiegsgeschwindigkeit des Eingangssignals nur geringfügig größer als die erste Pegeländerungsgeschwindigkeit $PG_1$ ist. Aufgrund der in der obigen Weise gewählten Verzögerungszeit $\Delta t_D$ erfolgt auf eine jeweilige Änderung des Eingangsspannungspegels $V_E$ hin ein Angleich des Bezugsspannungspegels $V_{ref}$ nämlich erst dann, wenn der Eingangsspannungspegel $V_E$ bei angenommen kontinuierlichem Anstieg den Schwellenwert $U_{Off}$ bereits erreicht hat, d.h. die Flanke bereits erkannt ist. Da sich während des Übergangs des Eingangssignals vom vorherigen Ruhespannungspegel zu einem um den Schwellenwert $U_{Off}$ höheren Wert der Bezugsspannungspegel $V_{ref}$ nicht geändert hat, entspricht dieser bis zur Abgabe des für das Auftreten der betreffenden Flanke repräsentativen Ausgangssignals $V_A$ noch dem vorherigen Ruhespannungspegel. Der Pegelvergleich erfolgt demnach in jedem Falle so, daß der Eingangsspannungspegel $V_E$ mit dem zuvor vorherrschenden Ruhespannungspegel verglichen und die jeweilige Spannungsänderung daraufhin überprüft wird, ob sie gegenüber diesem Ruhespannungspegel zu einer Änderung entsprechend dem Schwellenwert $U_{Off}$ geführt hat. Es ist somit ausgeschlossen, daß der Vergleich anhand eines sich während der Eingangsspannungsänderung ebenfalls ändernden Bezugsspannungspegels anstatt anhand des allein maßgeblichen vorherigen Ruhespannungspegels der Eingangsspannung durchgeführt wird.

Auch dann, wenn die Anstiegsgeschwindigkeit des Eingangssignals größer als die erste Pegeländerungsgeschwindigkeit $PG_1$ ist, erfolgt der Angleich des Bezugsspannungspegels $V_{ref}$ an den Eingangsspannungspegel $V_E$ erst nach der Verzögerungszeit $\Delta t_D$. Aufgrund der größeren Anstiegsgeschwindigkeit des Eingangssignals wird der Schwellenwert $U_{Off}$ in diesem Fall vor Ablauf dieser Verzögerungszeit $\Delta t_D$ erreicht. Auch in diesem Fall ist sichergestellt, daß ein für das Auftreten einer Flanke repräsentatives Ausgangssignal $V_A$ nur erzeugt wird, wenn sich der Eingangsspannungspegel $V_E$ genau um den vorgesehenen relativen Schwellenwert $U_{Off}$ gegenüber dem vorherigen Ruhespannungspegel geändert hat. Auch in diesem Fall bewirkt die Verzögerungszeit $\Delta t_D$ nämlich, daß sich der Bezugsspannungspegel $V_{ref}$ vor einem Erreichen des Schwellenwertes $U_{Off}$ nicht ändert.

Bleibt dagegen die Anstiegsgeschwindigkeit des Eingangssignals kleiner als die vorgebbare erste Pegeländerungsgeschwindigkeit $PG_1$, so kann der Ein-

gangsspannungspegel $V_E$ trotz der Verzögerungszeit $\Delta t_D$ den Schwellenwert $U_{Off}$ nicht erreichen. Nach dem Auftreten einer jeweiligen Spannungsänderung am Eingang kann sich der Eingangsspannungspegel $V_E$ zwar zunächst gegenüber dem Bezugsspannungspegel $V_{ref}$ ändern. Aufgrund der kleineren Anstiegsgeschwindigkeit wird bis zum Ablauf der Verzögerungszeit $\Delta t_D$ jedoch lediglich ein Differenzwert erreicht, der kleiner als der vorgebbare relative Schwellenwert $U_{Off}$ bleibt. Nach Ablauf der Verzögerungszeit $\Delta t_D$ wird der Bezugsspannungspegel $V_{ref}$ dann mit der höheren ersten Pegeländerungsgeschwindigkeit $PG_1$ an den Eingangsspannungspegel $V_E$ angeglichen, so daß die am zweiten Komparator 24 anliegende Spannungsdifferenz wieder kleiner wird. Der Schwellenwert $U_{Off}$ wird demnach nicht mehr erreicht, so daß der zweite Komparator 24 auch kein für eine jeweilige Flanke repräsentatives Ausgangssignal $V_A$ liefert.

Die vorgebbare erste Pegeländerungsgeschwindigkeit $PG_1$ ist durch den Wert des Lade-/Entladestroms $I_1$ der ersten Lade-/Entladeschaltung 16 und/oder die Kapazität des Kondensators C einstellbar (vgl Beziehung 1). Der relative Schwellenwert $U_{Off}$ ist unabhängig davon beispielsweise über eine entsprechende Gleichspannungsquelle einstellbar. Es ist dann lediglich dafür zu sorgen, daß auch die Verzögerungszeit $\Delta t_D$ entsprechend der obigen Beziehung 2 angepaßt wird.

Fig. 2 zeigt eine schematische Teilansicht einer zweiten Ausführungsform eines Flankendetektors, der sich von der gemäß Fig. 1 lediglich dadurch unterscheidet, daß dem als Speicherelement dienenden Kondensator C eine zweite Lade-/Entladeschaltung 26 zugeordnet ist. Im übrigen stimmt diese Ausführungsform mit der der Fig. 1 überein, wobei gleiche Elemente mit gleichen Bezugszeichen versehen sind.

Die zweite Lade-/Entladeschaltung 26 besitzt einen Steuereingang 28, der mit dem Ausgang des zweiten Komparators 24 des Vergleichskreises 12 verbunden und damit vom für das Auftreten einer jeweiligen Flanke repräsentativen Ausgangssignal $V_A$ beaufschlagt ist.

Diese zweite Lade-/Entladeschaltung 26 dient dazu, den am Kondensator C abgreifbaren Bezugsspannungspegel $V_{ref}$ in Abhängigkeit vom Auftreten des Ausgangssignals $V_A$ mit einer vorgebbaren zweiten Pegeländerungsgeschwindigkeit $PG_2$ an den um den vorgebbaren relativen Schwellenwert $U_{Off}$ verringerten Eingangsspannungspegel $V_E$ anzugleichen, wobei diese vorgebbare zweite Pegeländerungsgeschwindigkeit $PG_2$ größer als die erste $PG_1$ ist.

Diese zweite Lade-/Entladeschaltung 26 kann hierzu ein zweites Stromquellenpaar 26', 26" enthalten, um einen zweiten Lade- bzw. Entladestrom $I_2$ zu erzeugen, dessen Wert zusammen mit der Kapazität des Kondensators C die vorgebbare zweite Pegeländerungsgeschwindigkeit $PG_2$ bestimmt. Beim dargestellten Ausführungsbeispiel ist der Schaltungspunkt zwischen den beiden Stromquellen des zweiten Stromquellenpaares 26', 26" einerseits mit dem betreffenden Schaltungspunkt des ersten Stromquellenpaares 16', 16" und andererseits mit der der Masseseite gegenüberliegenden Seite des Kondensators C verbunden. Die eine Stromquelle 26' ist wiederum mit der Versorgungspannung $V_{CC}$ verbunden, während die andere Stromquelle 26" an Masse M liegt. Die zweite Pegeländerungsgeschwindigkeit ist durch die Beziehung

$$PG_2 = \Delta U_c / \Delta t = I_2 / C \qquad (3)$$

gegeben, mit

$$I_2 \gg I_1.$$

Sobald ein für das Auftreten einer jeweiligen Flanke repräsentatives Ausgangssignal $V_A$ auftritt, wird somit der Bezugsspannungspegel $V_{ref}$ auf einen solchen Wert gebracht, daß die Differenzspannung zwischen den Eingängen des zweiten Komparators 24 (vgl. Fig. 1) Null wird. Der sowohl einem Eingang des ersten Komparators 18 als auch einem Eingang des zweiten Komparators 24 zugeführte Bezugsspannungspegel $V_{ref}$ wird demnach mit der höheren zweiten Pegeländerungsgeschwindigkeit $PG_2$ auf den Wert $V_E - V_{Off}$ gebracht.

Zweckmäßigerweise ist diese zweite Pegeländerungsgeschwindigkeit $PG_2$ deutlich größer als die erste gewählt, so daß unmittelbar nach dem Auftreten eines für eine jeweilige Flanke repräsentativen Ausgangssignals $V_A$ der Bezugsspannungspegel $V_{ref}$ so schnell wie möglich nachgeführt bzw. an den um den vorgebbaren relativen Schwellenwert $U_{Off}$ verringerten Eingangsspannungspegel $V_E$ angeglichen wird. Zur Flankenerkennung ist es nämlich völlig ausreichend, wenn bei hinreichender Anstiegsgeschwindigkeit der vorgebbare Schwellenwert überschritten wird. Mit dieser zweiten Lade-/Entladeschaltung 26 können somit die jeweiligen Erholungszeiten beträchtlich verkürzt werden.

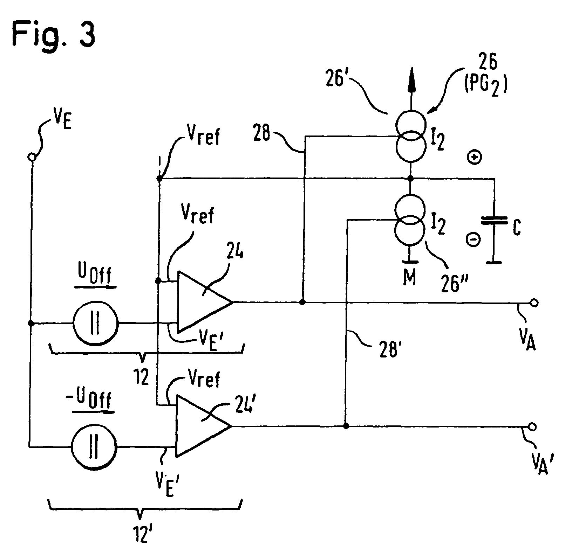

Fig. 3 zeigt einen Ausschnitt einer dritten Ausführungsform eines Flankendetektors, die sich von den beiden vorhergehenden Ausführungsformen zunächst dadurch unterscheidet, daß zwei Vergleichskreise 12, 12' vorgesehen sind, um für das Auftreten einer positiven bzw. negativen Flanke repräsentative Ausgangssignale $V_A$, $V_A'$ zu liefern, wenn sich der Eingangsspannungspegel $V_E$ in positiver bzw. negativer Richtung um wenigstens den vorgebbaren relativen Schwellenwert $U_{Off}$ gegenüber dem Bezugsspannungspegel $V_{ref}$ ändert. Hierzu weisen die verwendeten Gleichspannungsquellen eine unterschiedliche Polarität ($U_{Off}$, $-U_{Off}$) auf.

Auch in diesem Fall ist wiederum ein zweites Stromquellenpaar 26', 26" vorgesehen. Deren Stromquellen besitzen getrennte Steuereingänge 28, 28', die vom Ausgangssignal $V_A$ des einen bzw. vom Ausgangssignal $V_A'$ des anderen der beiden Vergleichskreise 12, 12' beaufschlagt sind.

Im übrigen besitzt diese Ausführungsvariante den gleichen Aufbau wie die beiden zuvor beschriebenen Ausführungsformen, so daß sich auch eine vergleichbare Funktionsweise ergibt.

Die Komparatoren 18, 24, 24' können zweckmäßigerweise jeweils einen Differenzverstärker enthalten. Das Zeitverzögerungsglied 14 kann vorzugsweise ein analoges Tiefpaßfilter enthalten.

## Patentansprüche

1. Flankendetektor zum Erzeugen von Ausgangssignalen in Abhängigkeit von positiven und/oder negativen Flanken eines Eingangssignals, **gekennzeichnet durch** einen Regelkreis (10), **durch** den ein an einem Speicherelement (C) abgreifbarer Bezugsspannungspegel ($V_{ref}$) mit einer vorgebbaren ersten Pegeländerungsgeschwindigkeit ($PG_1$) kontinuierlich an den Eingangsspannungspegel ($V_E$) angeglichen wird, **durch** wenigstens einen Vergleichskreis (12, 12'), der ein für das Auftreten einer Flanke repräsentatives Ausgangssignal ($V_A$, $V_A'$) liefert, wenn sich der Eingangsspannungspegel ($V_E$) um wenigstens einen vorgebbaren relativen Schwellenwert ($U_{Off}$) gegenüber dem Bezugsspannungspegel ($V_{ref}$) ändert, und **durch** ein im Regelkreis (10) enthaltenes Verzögerungsglied (14), dessen eine Verzögerung des Bezugsspannungspegelangleichs bewirkende Verzögerungszeit ($\Delta t_D$) gleich dem Verhältnis von dem vorgebbaren relativen Schwellenwert ($U_{Off}$) zu der vorgebbaren ersten Pegeländerungsgeschwindigkeit ($PG_1$) gewählt ist.

2. Flankendetektor nach Anspruch 1, **dadurch gekennzeichnet, daß** der das Verzögerungsglied (14) und das Speicherelement (C) enthaltende Regelkreis (10) ferner eine dem Speicherelement (C) zugeordnete erste Lade-/Entladeschaltung (16) und einen ersten Komparator (18) enthält, an dessen einem Eingang der Eingangsspannungspegel ($V_E$) und an dessen anderem Eingang der Bezugsspannungspegel ($V_{ref}$) anliegt, und daß der Ausgang des ersten Komparators (18) über das Verzögerungsglied (14) mit einem Steuereingang (20) der ersten Lade-/Entladeschaltung (16) verbunden ist.

3. Flankendetektor nach Anspruch 1 oder 2, **dadurch gekennzeichnet, daß** das Speicherelement einen Kondensator (C) enthält.

4. Flankendetektor nach Anspruch 3, **dadurch gekennzeichnet, daß** die erste Lade-/Entladeschaltung (16) ein erstes Stromquellenpaar (16', 16") enthält, um einen ersten Lade- bzw. Entladestrom ($I_1$) zu erzeugen, dessen Wert zusammen mit der Kapazität des Kondensators (C) die vorgebbare erste Pegeländerungsgeschwindigkeit ($PG_1$) bestimmt.

5. Flankendetektor nach einem der vorhergehenden Ansprüche, **dadurch gekennzeichnet, daß** ein im Vergleichskreis (12, 12') enthaltener zweiter Komparator (24, 24') vorgesehen ist, an dessen einem Eingang ein Spannungspegel ($V_E'$) anliegt, der gleich dem um den vorgebbaren relativen Schwellenwert ($U_{Off}$) verringerten Eingangsspannungspegel ($V_E$) ist, und an dessen anderem Eingang der Bezugsspannungspegel ($V_{ref}$) anliegt, und daß das für das Auftreten einer jeweiligen Flanke repräsentative Ausgangssignal ($V_A$, $V_A'$) des Vergleichskreises (12, 12') vom zweiten Komparator (24, 24') erzeugt wird.

6. Flankendetektor nach einem der vorhergehenden Ansprüche, **dadurch gekennzeichnet, daß** dem Speicherelement (C) eine zweite Lade-/Entladeschaltung (26) zugeordnet ist, die einen Steuereingang (28, 28') aufweist, der vom Ausgangssignal ($V_A$, $V_A'$) des Vergleichskreises (12, 12') beaufschlagt ist, um den am Speicherelement (C) abgreifbaren Bezugsspannungspegel ($V_{ref}$) in Abhängigkeit vom Auftreten des Ausgangssignals ($V_A$, $V_A'$) mit einer vorgebbaren zweiten Pegeländerungsgeschwindigkeit ($PG_2$) an den um den vorgebbaren relativen Schwellenwert ($U_{Off}$) verringerten Eingangsspannungspegel ($V_E$) anzugleichen, und daß die vorgebbare zweite Pegeländerungsgeschwindigkeit ($PG_2$) größer als die erste ($PG_1$) ist.

7. Flankendetektor nach Anspruch 6, **dadurch gekennzeichnet, daß** die zweite Lade-/Entladeschaltung (26) ein zweites Stromquellenpaar (26', 26") enthält, um einen zweiten Lade- bzw. Entladestrom ($I_2$) zu erzeugen, dessen Wert zusammen mit der Kapazität des Kondensators (C) die vorgebbare zweite Pegeländerungsgeschwindigkeit ($PG_2$) bestimmt.

8. Flankendetektor nach einem der vorhergehenden Ansprüche, **dadurch gekennzeichnet, daß** zwei Vergleichskreise (12, 12') vorgesehen sind, um für das Auftreten einer positiven bzw. negativen Flanke repräsentative Ausgangssignale ($V_A$, $V_A'$) zu liefern, wenn sich der Eingangsspannungspegel ($V_E$) in positiver bzw. negativer Richtung um wenigstens den vorgebbaren relativen Schwellenwert ($U_{Off}$) gegenüber dem Bezugsspannungspegel ($V_{ref}$) ändert.

9. Flankendetektor nach Anspruch 7 und 8, **dadurch**

**gekennzeichnet, daß** die Stromquellen des zweiten Stromquellenpaares (26', 26") getrennte Steuereingänge (28, 28') aufweisen, die vom Ausgangssignal ($V_A$) des einen bzw. vom Ausgangssignal ($V_A$') des anderen der beiden Vergleichskreise (12, 12') beaufschlagt sind.

10. Flankendetektor nach einem der vorhergehenden Ansprüche, **dadurch gekennzeichnet, daß** die beiden Stromquellen eines jeweiligen Stromquellenpaares (16', 16"; 26', 26") gegensinnig angesteuert werden.

11. Flankendetektor nach einem der vorhergehenden Ansprüche, **dadurch gekennzeichnet, daß** die Komparatoren (18, 24, 24') jeweils durch einen Differenzverstärker gebildet sind.

**Claims**

1. An edge detector for producing output signals in dependence on positive and/or negative edges of an input signal, **characterized by** a control loop (10), by which a reference voltage level ($V_{ref}$) available across a storage element (C) is continuously assimilated at a predeterminable first level change rate ($PG_1$) to the input voltage level ($V_E$), by at least one comparison circuit (12, 12'), which supplies an output signal ($V_A$, $V_A$') indicative of the occurrence of an edge when the input voltage level ($V_E$) changes by at least a predeterminable relative threshold value ($U_{off}$) in relation to the reference voltage level ($V_{ref}$), and by a delay means (14) comprised in the control loop (10), whose delay time ($\Delta t_D$) causing a delay in the assimilation of the reference voltage level is selected to be equal to the ratio of the predeterminable relative threshold value ($U_{off}$) to the predeterminable first level change rate ($PG_1$).

2. The edge detector as claimed in claim 1, **characterized in that** the control loop (10) comprising the delay means (14) and the storage element (C) furthermore includes a first charge and discharge circuit (16) associated with the storage element (C) and a first comparator (18), whose one input receives the input voltage level ($V_E$) and whose other input receives the reference voltage level ($V_{ref}$), and **in that** the output of the first comparator (18) is connected via the delay means (14) with a control input (20) of the first charge and discharge circuit (16).

3. The edge detector as claimed in claim 1 or in claim 2, **characterized in that** the storage element includes a capacitor (C).

4. The edge detector as claimed in claim 3, **characterized in that** the first charge and discharge circuit (16) comprises a first current source pair (16', 16") in order to produce a first charge and discharge current ($I_1$), whose value together with the capacitance of the capacitor (C) sets the predeterminable first level change rate ($PG_1$).

5. The edge detector as claimed in any one of the preceding claims, **characterized in that** a second comparator (24, 24') contained in the comparison circuit (12, 12') is provided, whose one input receives a voltage level ($V_E$'), which is equal to the input voltage level ($V_E$) reduced by the predeterminable relative threshold value ($U_{off}$) and whose other input receives the reference voltage level ($V_{ref}$), and **in that** the output signal ($V_A$, $V_A$') indicative of the occurrence of a respective edge of the comparison circuit (12, 12') is produced by the second comparator (24, 24').

6. The edge detector as claimed in any one of the preceding claims, **characterized in that** a second charge and discharge circuit (26) is associated with the storage element (C) and has a control input (28, 28'), which is acted upon by the output signal ($V_A$, $V_A$') of the comparison circuit (12, 12') in order to assimilate the reference voltage level ($V_{ref}$) available at the storage element (C) in dependence on the occurrence of the output signal ($V_A$, $V_A$') at a predeterminable second level change rate ($PG_2$) to the input voltage level ($V_E$) reduced by the predeterminable relative threshold value ($D_{off}$), and **in that** the predeterminable second level change rate ($PG_2$) is larger than the first one ($PG_1$).

7. The edge detector as claimed in claim 6, **characterized in that** the second charge and discharge circuit (26) includes a second current source pair (26', 26") in order to produce a second charge and discharge current ($I_2$) whose value together with the capacitance of the capacitor (C) sets the predeterminable second level change rate ($PG_2$).

8. The edge detector as claimed in any one of the preceding claims, **characterized in that** two comparison circuits (12, 12') are provided in order to supply output signals ($V_A$, $V_A$') indicative of the occurrence of a positive or a negative edge when the input voltage level ($V_E$) changes in a positive or, respectively, negative direction by at least the predeterminable relative threshold value ($U_{off}$) in relation to the reference voltage level ($V_{ref}$).

9. The edge detector as claimed in claim 7 and claim 8, **characterized in that** the current sources of the second current source pair (26', 26") have separate control inputs (28, 28'), which are acted upon by the output signal ($V_A$) of the one or, respectively, by the output signal ($V_A$') of the other of the two comparison circuits (12, 12').

10. The edge detector as claimed in any one of the preceding claims, **characterized in that** the two current sources of a respective current source pair (16', 16''; 26', 26'') are driven oppositely.

11. The edge detector as claimed in any one of the preceding claims, **characterized in that** the comparators (18, 24, 24') are each constituted by a differential amplifier.

## Revendications

1. Détecteur de flancs pour produire des signaux de sortie en fonction de flancs positifs et/ou négatifs d'un signal d'entrée, **caractérisé par** un circuit de régulation (10), au moyen duquel un niveau de tension de référence ($V_{ref}$) pouvant être prélevé sur un élément de mémoire (C) est asservi d'une manière continue sur le niveau de tension d'entrée ($V_E$) avec une première vitesse ($PG_1$) de changement de niveau pouvant être prédéterminée, et par au moins un circuit comparateur (12,12'), qui délivre un signal de sortie ($V_A$, $V_A$') représentatif de l'apparition d'un flanc, lorsque le niveau de tension d'entrée ($V_E$) varie au moins d'une valeur de seuil relative pouvant être prédéterminée ($U_{Off}$) par rapport au potentiel de tension de référence ($V_{ref}$), et par un circuit de retardement (14), qui est contenu dans le circuit de régulation (10) et dont un temps de retard ($\Delta t_D$), qui produit un retardement de l'équilibrage du niveau de tension de référence, est choisi égal au rapport de la valeur de seuil relative pouvant être prédéterminée ($U_{Off}$) à la première vitesse ($PG_1$) pouvant être prédéterminée de variation de niveau.

2. Détecteur de flancs selon la revendication 1, **caractérisé en ce que** le circuit de régulation (10), qui contient le circuit de retardement (14) et l'élément de mémoire (C), contient en outre un premier circuit de charge / décharge (16), qui est associé à l'élément de mémoire (C), et un premier comparateur (18), à une entrée duquel est appliqué le niveau de tension d'entrée ($V_E$) et à l'autre entrée duquel est appliqué le niveau de tension de référence ($V_{ref}$) et que la sortie du premier comparateur (18) est reliée par l'intermédiaire du circuit de retardement (14) à une entrée de commande (20) du premier circuit de charge/décharge (16).

3. Détecteur de flancs selon la revendication 1 ou 2, **caractérisé en ce que** l'élément de mémoire contient un condensateur (C).

4. Détecteur de flancs selon la revendication 3, **caractérisé en ce que** le premier circuit de charge/décharge (16) contient une première paire de sources de courant (16', 16'') servant à produire un premier courant de charge ou de décharge ($I_1$), dont la valeur détermine, conjointement avec la capacité du condensateur (C), la première vitesse pouvant être prédéterminée de variation de niveau ($PG_1$).

5. Détecteur de flancs selon l'une des revendications précédentes, **caractérisé en ce qu'**il est prévu un second comparateur (24,24'), qui est contenu dans le circuit comparateur (12,12') et à une entrée duquel est appliqué un niveau de tension ($V_E$'), qui est égal au niveau de tension d'entrée ($V_E$) diminué de la valeur de seuil relative pouvant être prédétermine ($U_{Off}$) et à l'autre entrée duquel est appliqué le niveau de tension de référence ($V_{ref}$), et que le signal de sortie ($V_A$, VA') représentatif de l'apparition d'un flanc respectif, du circuit comparateur (12,12') est produit par le second comparateur (24,24').

6. Détecteur de flancs selon l'une des revendications précédentes, **caractérisé en ce qu'**à l'élément de mémoire (C) est associé un second circuit de charge/décharge (26), qui comporte une entrée de commande (28,28'), qui est chargée par le signal de sortie ($V_A$, $V_A$') du circuit comparateur (12, 12'), pour équilibrer le niveau de tension de référence ($V_{ref}$) pouvant être prélevé dans l'élément de mémoire (C), en fonction du signal de sortie ($V_A$, $V_A$') avec une seconde vitesse pouvant être prédéterminée de variation de niveau ($PG_2$) au niveau de tension d'entrée ($V_E$) diminué de la valeur de seuil relative pouvant être prédéterminée ($U_{Off}$), et que la seconde vitesse ($PG_2$) pouvant être prédéterminée de modification du niveau est supérieure à la première vitesse ($PG_1$).

7. Détecteur de flancs selon la revendication 6, **caractérisé en ce que** le second circuit de charge/décharge (26) contient une seconde paire de sources de courant (26', 26'') pour produire un second courant de charge ou de décharge ($I_2$), dont la valeur détermine, conjointement avec la capacité du condensateur (C), la seconde vitesse ($PG_2$) pouvant être prédéterminée de modification du niveau.

8. Détecteur de flancs selon l'une des revendications précédentes, **caractérisé en ce que** deux circuits comparateurs (12, 12') sont prévus pour délivrer des signaux de sortie ($V_A$, $V_A$') représentatifs de l'apparition d'un flanc positif ou d'un flanc négatif, lorsque le niveau de tension d'entrée ($V_E$) varie dans le sens positif ou dans le sens négatif d'au moins la valeur de seuil relative pouvant être prédéterminée ($U_{Off}$) par rapport au niveau de tension de référence($V_{Ref}$).

9. Détecteur de flancs selon les revendications 7 et 8, **caractérisé en ce que** les sources de courant de la seconde paire de sources de courant (26', 26") comportent des entrées de commande séparées (28, 28') qui sont chargées par le signal de sortie ($V_A$) de l'un des deux circuits comparateurs (12, 12') et par le signal de sortie ($V_A'$) de l'autre des deux circuits comparateurs (12, 12').

10. Détecteur de flancs selon l'une des revendications précédentes, **caractérisé en ce que** les deux sources de courant d'une paire respective de sources de courant (16', 16"; 26', 26") sont commandées dans le même sens.

11. Détecteur de flancs selon l'une des revendications précédentes, **caractérisé en ce que** les comparateurs (18, 24, 24') sont formés respectivement par un amplificateur différentiel.

# Fig. 1

# Fig. 2

$I_2 \gg I_1$

# Fig. 3